# EUROPEAN PATENT APPLICATION

(11) **EP 4 579 734 A1**
(43) Date of publication of application: **02.07.2025**
(21) Application number: 24195209.2
(22) Date of filing: 19.08.2024
(51) Int. Cl.: H01L 23/495, H01L 23/31

(54) **HYBRID BALL/BUMP AND WIREBOND SEMICONDUCTOR DEVICE PACKAGING**

(30) Priority: 28.12.2023 CN 202311841888
(71) Applicant: NXP USA, Inc., Austin, TX 78735 (US)
(72) Inventor: Descartin, Allen Marfil, 5656AG Eindhoven (NL); Ching Jr., Mariano Layson, 5656AG Eindhoven (NL); Li, Jun, 5656AG Eindhoven (NL)
(74) Representative: Hardingham, Christopher Mark

(57) **Abstract**

Disclosed is a packaged semiconductor device, comprising: a semiconductor die, having an array of contact pads, in a central region of a first major surface thereof and for contacting to an array of solder balls; encapsulant, partially encapsulating the semiconductor die and having an aperture in a first major surface thereof exposing the array of contact pads; and a plurality of leads extending from side faces of the encapsulant and extending beyond the first major surface of the encapsulant. Corresponding methods are also disclosed.

## Description

### Field

The present disclosure relates to packaged semiconductor devices having both solder bumps or balls, and leads, for interconnection, and to associated methods of manufacture.

### Background

Widely used conventional methods for packaging semiconductor devices involve wirebonding individual contact pads from an integrated circuit onto individual leads of a lead frame. Whilst being effective and versatile, the techniques are time-consuming and thus expensive, since generally the wire bonds must be created one by one. Many advanced packaging techniques have been developed and introduced to overcome this, for example use of a so-called flip-chip package which has a die with bumps on its active surface; the die is flipped over and connected to a substrate using for example solder balls. Other techniques include wafer-level packaging in which the die size package consisting of a repassivation of a die with signal paths redistributed to more widely spaced solder bumps which may then be directly mounted onto printed-wiring boards.

### Summary

According to a first aspect of the present disclosure, there is provided a packaged semiconductor device, comprising: a semiconductor die, having an array of contact pads, in a central region of a first major surface thereof and for contacting to an array of solder balls, bumps or pillars; encapsulant, partially encapsulating the semiconductor die and having an aperture in a first major surface thereof exposing the array of contact pads; and a plurality of leads extending from side faces of the encapsulant and extending beyond the first major surface of the encapsulant. By only partially encapsulating the semiconductor die, a central region of its surface may be left exposed. By exposing the central region of the first major surface of the semiconductor die, bump bonding or ball grid array bonding or the like may be used in order to provide electrical connections to the die, whilst taking advantage of additional connections are provided by the wire bonds between other contacts on the die, and the plurality of leads. In one or more embodiments, the device further comprises the array of solder balls, or bumps, or metal-based pillars such as copper-pillars.

In one or more embodiments the solder balls extend further beyond the first surface of the encapsulant than do an end part of the leads, which have an "L" shaped profile. Subsequent connection of the solder balls to a substrate such as a circuit board may thus result in mechanical and electrical connection of the solder balls to the circuit board wherein the solder balls may be somewhat deformed or "squashed" whilst allowing the leads to provide further electrical connection to the circuit board without requiring significant deformation of the leads.

In one or more embodiments, the leads have a "J" shaped profile, and have an end part which extends beyond, and curves back underneath and towards, the first major surface of the encapsulant. This may assist in anchoring the leads to a circuit board during subsequent soldering of the leads to the circuit board. It may further provide a degree of tolerance allowing for differential thermal expansion during use.

In one or more embodiments, the packaged semiconductor device further comprises a substrate connected to the semiconductor die by the leads and by the solder balls attaching the contact pads. The substrate may be a circuit board or a laminate board or made from other suitable materials with which the skilled person will be familiar.

The semiconductor die may further comprise a further plurality of contact pads around its periphery. The further plurality of contact pads may be distributed around four sides of the periphery, or may be localised to fewer than four sides. For instance, they may be provided on two, opposite, sides of the periphery. Their position and number may depend on the requirements for the number of separate electrical contacts required by the IC or by, for example, any requirement for localised signal paths into and out of the IC.

In one or more embodiments, the leads are connected to the further plurality of contact pads by wire bonds. The form of the wire bonds may be chosen to suit the particular manufacturing technology and application. For example in applications in which high power is required the bond wires may be chosen to be relatively thick and at a relatively wide pitch; in other applications wherein there is not a requirement for high-power, thinner wire may be selected, and the wire bonds may be made at a finer pitch - that is to say with less separation between them relative to the high power applications.

In one or more embodiments, the leads may be part of a lead frame assembly which further comprises a die-pad attaching to a second major surface of the semiconductor die.

According to a second aspect of the present disclosure, there is provided a method of fabricating a packaged semiconductors die, the method comprising: performing die-attach between a semiconductor die and a lead-frame assembly; wirebonding peripheral contact pads on the semiconductor die to leads of the lead-frame assembly; encapsulating the semiconductor die in encapsulant, and providing an aperture in a first major surface of the encapsulant exposing a contact pad array on the semiconductor die; forming the leads to extend beyond the first major surface of the encapsulant.

The method may further comprise, before the step of forming the leads, the step of: providing, on the contact pad array, a one of a group consisting of solder balls, solder bumps, or copper pillars. Moreover, the method may further comprise, after the step of encapsulating the semiconductor die in encapsulant, the step of providing, on the contact pad array, a one of a group consisting of solder balls, solder bumps, or copper pillars.

These and other aspects of the invention will be apparent from, and elucidated with reference to, the embodiments described hereinafter.

### Brief description of Drawings

Embodiments will be described, by way of example only, with reference to the drawings, in which:
FIG. 1 shows a schematic view of a semiconductor die or integrated circuit, prior to packaging, according to one or more embodiments of the present disclosure;
FIG. 2 shows a schematic view of a semiconductor die or integrated circuit, prior to packaging, according to one or more other embodiments of the present disclosure;
FIG. 3 shows a schematic view of yet another semiconductor die or integrated circuit, consistent with the present disclosure;
FIG. 4 shows a schematic cross-section through a packaged semiconductor device 400 according to one or more embodiments of the present disclosure;
FIG. 5 shows, schematically, a side view of the packaged semiconductor device illustrated in FIG. 4;
FIG. 6 shows a packaged semiconductor device according to one or more other embodiments of the present disclosure;
FIG. 7 shows a side view of a packaged semiconductor device illustrated in FIG. 6;
FIG. 8 illustrates the mounting of a packaged semiconductor device according to one or more embodiments on a substrate;
FIG. 9 illustrates the mounting of a packaged semiconductor device according to one or more other embodiments on a substrate;
FIG. 10 shows a section through an assembly comprising a packaged semiconductor device mounted on a substrate;
FIG. 11 shows a schematic side view of the assembly of FIG. 10;
FIG. 12 shows schematically a manufacturing flow for a packaged semiconductor die according to embodiments of the present disclosure;
FIG. 13 shows an alternative manufacturing flow for assembly of a packaged semiconductor device according to one or more other embodiments of the disclosure; and
FIG. 14 shows yet another alternative variant of the process flow.

It should be noted that the FIG.s are diagrammatic and not drawn to scale. Relative dimensions and proportions of parts of these FIG.s have been shown exaggerated or reduced in size, for the sake of clarity and convenience in the drawings. The same reference signs are generally used to refer to corresponding or similar features in modified and different embodiments.

### Detailed description of embodiments

The present disclosure is concerned with packaged semiconductor die and associated methods of manufacturing packaged semiconductor die in which a combination of wire bond connections to individual leads of a lead frame, and bump bonding such as ball grid array, is deployed.

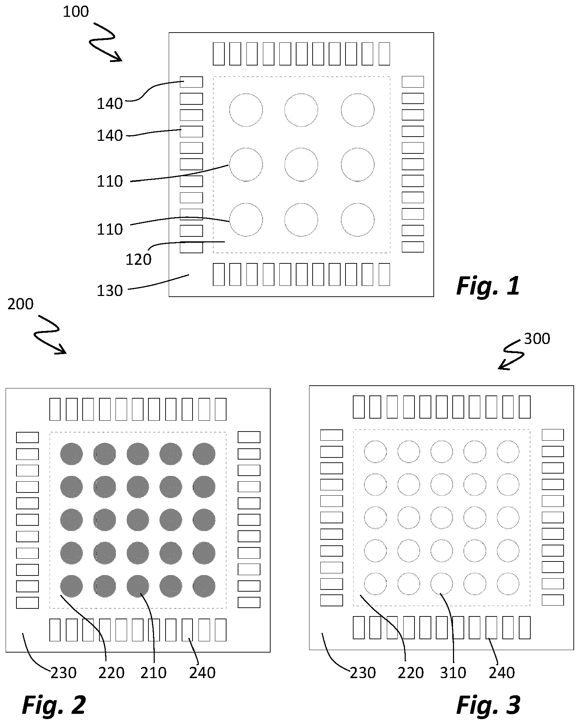

FIG. 1 shows a schematic view of a semiconductor die or integrated circuit 100, prior to packaging, according to one or more embodiments of the present disclosure. The die has a plurality of contact pads 110 in a central region 120 of its first major surface, which may also be referred to as its active surface. The contact pads may have solder thereon. The plurality of contact pads 110 may be arranged in an array, as shown. Around a peripheral region 130 of the semiconductor die are positioned a plurality of bonding pads 140. The bonding pads 140 may be arranged around all four sides of the semiconductor die or may be arranged on fewer than four sides for instance on only two sites.

FIG. 2 shows a schematic view of a semiconductor die or integrated circuit 200, prior to packaging, according to one or more other embodiments of the present disclosure. The die has a plurality of solder balls or bumps 210 in a central region 220 of its first major surface. The plurality of solder balls or bumps 210 may be arranged in an array. Similar to the die shown in FIG. 1, around a peripheral region 230 of the semiconductor die are positioned a plurality of bonding pads 240, which may be arranged around all four sides of the semiconductor die or may be arranged on less than four sides for instance on only two sides. The skilled person will appreciate that, within the scope of the present disclosure, as an alternative to solder balls or solder bumps, other types of bumps may be used: for instance, and without limitation, pillars of metal may be provided on the surface. Commonly, copper is used as the metal, or as part of a metal-based alloy, so this alternative may be referred to as copper pillars. Such metals or metal-based alloys may be deposited for instance by plating or printing, in a paste-form through a mask. FIG. 3 shows a schematic view of yet another semiconductor die or integrated circuit 300, consistent with the present disclosure. This time the die is similar to that shown in FIG. 2, except that the solder balls or bumps 210 are not present, and instead, individual contact pads 310 suitable for solder balls or bumps are shown.

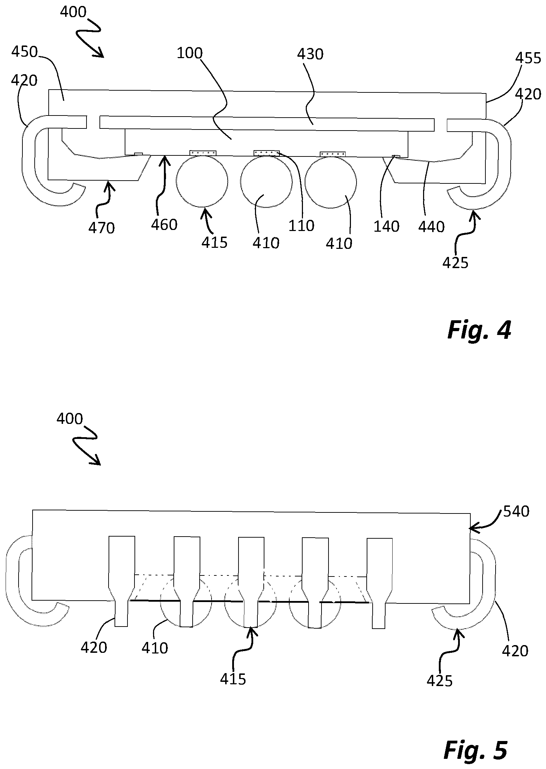

FIG. 4 shows a schematic cross-section through a packaged semiconductor device 400 according to one or more embodiments of the present disclosure. The packaged semiconductor device comprises a semiconductor die 100 such as that shown in FIG. 1, having a plurality of contact pads 110 which may be, as shown arranged in an array, and attached to which are a plurality of solder balls 410, in a central region of a first major surface thereof and for contacting to an array of solder balls or bumps 410, may be made of materials familiar to those skilled in the art of semiconductor packaging, such as, without limitation, a Sn/Ag alloy or a Sn/Ag/Cu alloy. Similarly the contact pads 110 may be made of any suitable material, such as copper, nickel, or aluminum, again as will be familiar to the skilled person. The contact pads 110 and solder balls or bumps 410 are arranged generally over a central region of the die 100.

The packaged semiconductor device further comprises a plurality of leads 420, two of which are shown in the FIG. 4. The leads may be part of a lead frame assembly which may, as shown, include a die paddle or die pad 430 which is bonded, for example using solder (not shown) to the second major surface of the semiconductor die. Individual leads 420 are physically separated and electrically isolated from the die pad 430, for example using conventional packaging processing techniques. The leads 420 are electrically connected to bonding pads 140 arranged around a peripheral region of the die 100, by means of bond wires 440 which are wire-bonded to the bonding pads 140 and leads 420 by conventional techniques such as wedge bonding or ball-bonding, or a combination thereof. In one or more embodiments, the wire looping profile, that is to say the height of the wire bonds above the surface of the die, may be minimised, in order to facilitate a shallow packaged device.

The packaged semiconductor device further includes encapsulant 450, typically of a moulding compound, again as will be familiar to the skilled person. This encapsulant moulding compound (EMC) partially encapsulates the semiconductor die. In particular, it has an aperture 460 in its first major surface 470. That is to say, the encapsulant does not extend over the central region 120 of the semiconductor die 100. The aperture 460 exposes the array of contact pads 110. The thickness of the encapsulant over the peripheral region of the first major surface is less than the thickness - that is to say the diameter - of the solder balls 410. According to one or more embodiments, the leads 420 extend beyond the encapsulant - that is to say they protrude beyond a sidewall 455 of the moulding compound. The leads are formed such as to extend beyond the first major surface of the semiconductor die; that is to say, in the orientation shown in the FIG. the leads extend downwardly. In the embodiment shown in FIG. 4, the leads are formed to have a re-entrant profile, that is to say they have a "J" shape (aligned sideways in the orientation shown in FIG. 4). The leads thus have an end part which extends beyond, and curves back underneath, the first major surface 470 of the encapsulant. Moreover, the extremity of end part may be formed so as to extend back (upwards as drawn) towards the first major surface 470 of the encapsulant. The leads may be formed such that they protrude beyond the first major surface of the die 100, to the same, or a lesser extent than the solder balls. In other words, in the orientation shown in FIG. 4, the bottom 415 of the solder balls may be level with or below the bottom 425 of the leads. Such an arrangement, in which the lower surface of the solder ball is below, and in particular is only a small distance below (such as 50 µm for a typical solder ball) the bottom or lower surface 425 of the leads, may be beneficial to help control the degree of solder ball collapse or solderable damaged during subsequent mounting of the packaged semiconductor device onto a board.

FIG. 5 shows, schematically, a side view of the packaged semiconductor device 400 illustrated in FIG. 4. In particular, in this embodiment, the lowermost surface of the leads 420 is at the same depth as the bottom of the solder balls 410. The side face 540 of the moulding compound may be vertical as shown or may include an angled profile, such as will be familiar to the skilled person. The aperture in the encapsulant, which is not visible in the side view of the device, is shown in a dotted profile for increased understanding of the embodiment.

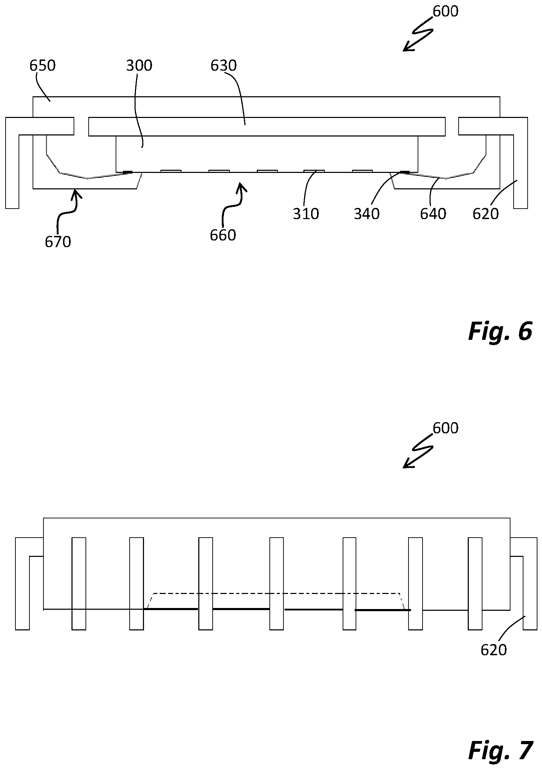

FIG. 6 shows a packaged semiconductor device 600 according to one or more other embodiments of the present disclosure. The FIG. includes a semiconductor die 300 having thereon a plurality of contact pads 310 in a central region of a first major surface thereof, the contact pads are arranged in an array, which may have a smaller pitch than the array illustrated in FIG. 1. The packaged semiconductor device 600 further includes a plurality of leads 620, which may form part of a lead frame assembly along with die paddle or die pad 630. The packaged semiconductor device 600 furthermore comprises moulding compound or EMC 650 which partially encapsulates the die 300. The moulding compound 650 has a gap, hole or aperture 660 in its lower major surface 670, which aperture exposes a central region of the die 300, and in particular the contact pads 310. The die 300 has a further plurality of contact pads 340 arranged around its periphery. These contact pads are electrically connected to the lead 620 by means of bond wires 640. The bond wires may be arranged, as shown, to have a low wire loop. The leads 620 are "L"-shaped; that is to say they extend outwards beyond the moulding compound 650 and are formed to extend towards and beyond the first major surface of the die and the first major surface 670 of the moulding compound. In the orientation shown in the FIG., this means that the ends of the leads extend down and beyond the lower surface 670 of the moulding compound. Compared with the embodiment shown in FIG. 4 and FIG. 5, the encapsulant may have a thinner mould (that is to say it's thickness below the die is less that the thickness of the encapsulant 450 below the die of the embodiment shown in FIG. 4) and thus has a shallower cavity depth or aperture depth exposing the central region of the surface of the die 300. The skilled person will appreciate that this may be matched to an appropriate size of solder bump for the final part of die attach (not shown in FIG. 6). The "L"-shaped configuration of the formed leads may assist in anchoring the device to a PCB board to which it may be subsequently bonded, and furthermore may aid in controlling the solder bump collapse or damage during the subsequent mounting of the packaged device onto a board.

FIG. 7 shows a side view of a packaged semiconductor device 600 as described above with respect to FIG. 6. The "L"-shaped profile of the leads is visible in each of the end leads 620. The aperture, which is not visible in the device, is depicted dashed, in order to aid the understanding of the present disclosure.

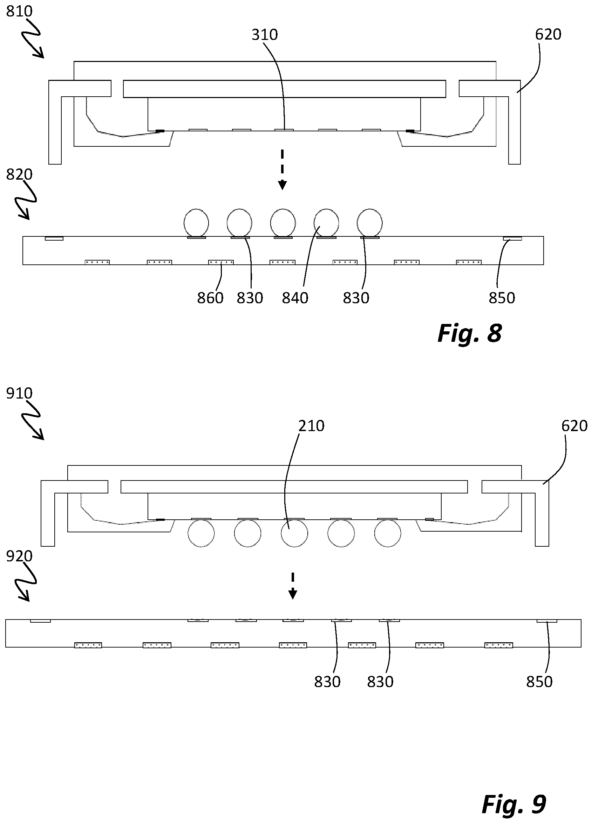

FIG. 8 illustrates the mounting of a packaged semiconductor device 810 according to one or more embodiments on a substrate 820. The packaged semiconductor device 810 may be similar to device 600 shown in FIG. 6 and FIG. 7, and comprises leads 620 and exposed contact pads 310 in an exposed area of the die at in the aperture 660. The substrate 820 includes contact pads 830 having solder balls or solder bumps 840 thereon, and thus may alternatively be described as a "pre-bumped substrate". It includes, on the same side as the solder balls or solder bumps, further contact pads 850 for connection to the external leads. The further contact pads 850 may be pre-soldered, that is to say they may have a solder layer thereon. The substrate may include a redistribution layer, which comprises electrically conductive tracks between, on a first surface, the solder balls or bumps 840 and lead contact pads 850 and, on a second surface opposite the first surface, further solder pads 860. The further solder pads may be spaced further apart or otherwise arranged for connection of further components such as discrete components or electrical wires or the like. During the mounting operation, the packaged semiconductor device 810 is aligned with the substrate 820 and the solder balls or bumps 840 bought into contact with the contact pads 310 on the die. A thermal process is used to soften or melt the solder and achieve electrical contact and a mechanical contact. At the same time the "L"-profile leads 620 make electrical contact with the contact pads 850, and solder therebetween effects electrical contact and a mechanical bond.

FIG. 9 illustrates the mounting of a packaged semiconductor device 910 according to one or more embodiments on a substrate 920. The packaged semiconductor device 910 is similar to that 810 shown in FIG. 8, except that the semiconductor die already has solder balls or bumps 210 mounted thereon, corresponding to the die shown in FIG. 2. Correspondingly, the substrate 920 does not have solder balls or bumps on the contact pads 830. Similar to the process illustrated in FIG. 8, the packaged semiconductor device 910 is aligned with the substrate 920 and the solder balls or bumps brought into contact with the contact pads 830.

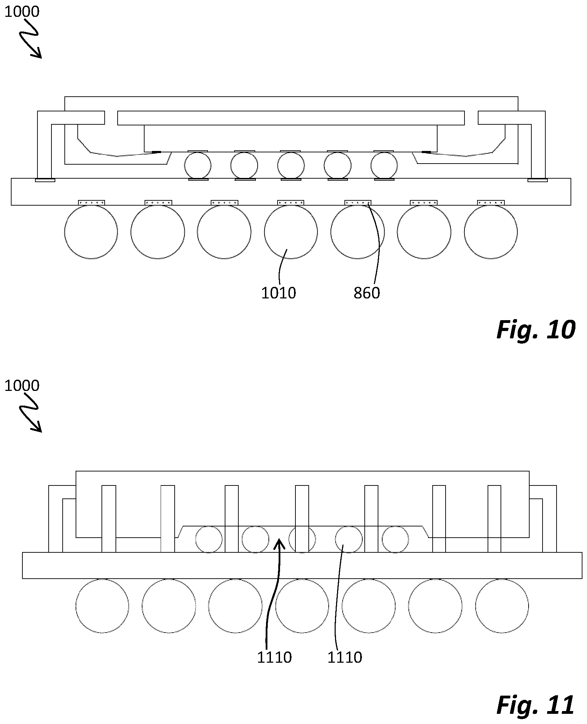

FIG. 10 shows a section through an assembly 1000 comprising a packaged semiconductor device 810 mounted on a substrate 820. The substrate has, on its lower or second surface, further solder balls 1010 on the further solder pads 860. FIG. 11 shows a schematic side view of the assembly 1000, in which the aperture 1110 in the moulding compound and the solder balls or bumps 840 between the semiconductor die and the substrate are shown hashed, in order to aid understanding of the disclosure.

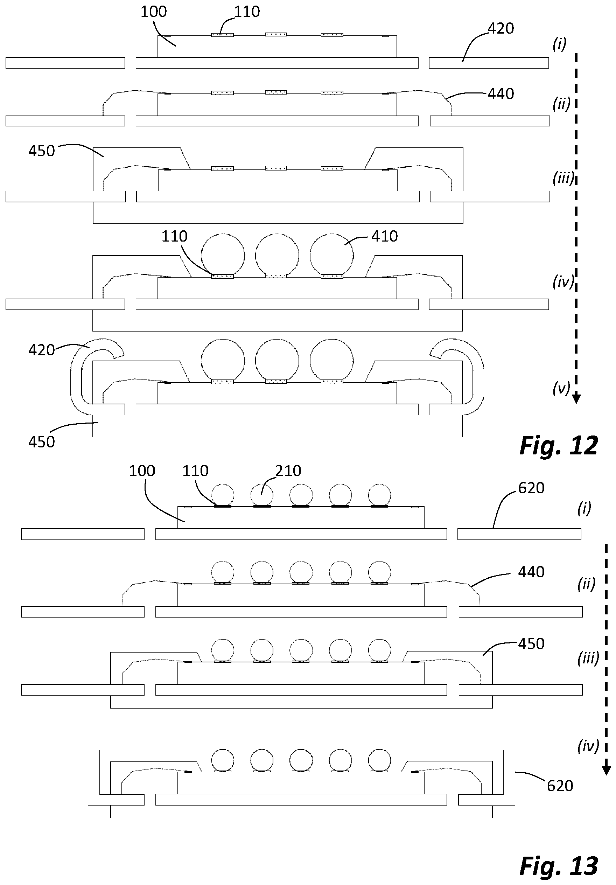

Turning to FIG. 12, this shows schematically a manufacturing flow for a packaged semiconductor die according to embodiments of the present disclosure. In the example shown, the semiconductor die 100 corresponds to that shown in FIG. 1 and includes a plurality of contact pads 110 in a central region 120 of its first major surface. The result of a first stage, being that of die attach between a semiconductor die and a lead frame assembly including electrical isolation of the leads from the die paddle, is shown at (i). Die attach may be performed by conventional means familiar to those skilled in the art of semiconductor packaging. At (ii) is shown the result of a second stage, that of wirebonding peripheral contact pads or bonding pads 140 on the semiconductor die to leads 420 of the lead-frame assembly, by means of bond wires 440. Again, this may be performed by conventional means familiar to those skilled in the art of semiconductor packaging. At (iii) is shown the result of a third stage, that of encapsulating the semiconductor die in encapsulant moulding compound 450. This step is partial encapsulation, since a central region of the first major surface is left exposed, and thus it provides an aperture, or gap, in a first major surface of the encapsulant exposing a contact pad array on the semiconductor die. At (iv) is shown the result of a further stage, that of solder ball attach, in which solder balls 410 are attached to the contact pads 110, again using known techniques. At (v) is showing the result of a further stage, that of forming the leads 420 to extend beyond the first major surface of the encapsulant. In the embodiment shown in FIG. 12, the leads have a "J" shaped profile oriented such that the extremity of the ends are turned back towards the encapsulant 450.

Turning now to FIG. 13, this shows an alternative manufacturing flow for assembly of a packaged semiconductor device according to one or more other embodiments of the disclosure. In this, nonlimiting, example the semiconductor die 100 includes solder balls or solder bumps 210 pre-attached to the contact pads 110, corresponding in this case to the bump IC die shown in FIG. 9. At (i) is shown the results of die attach of the semiconductor die 100 to the lead frame assembly including leads 620. This stage is generally similar to that shown in the process flow of FIG. 12, the skilled person will appreciate that modifications may be required due to the presence of the solder balls or bumps 210. Similarly, the wire bond stage, the result of which is shown at (ii) is similar to that shown in FIG. 12 as is the encapsulation in mould compound, the result of which is depicted in (iii). Since there are already solder balls or bumps on the die, the process stage corresponding to (iv) in the flow depicted in FIG. 12 is not required, and the process moves straight to the stage of forming the leads, in this instance to result in the "L"-shaped profile in which the end of the leads extends beyond the height of the die and the height of the encapsulant, to be generally similar to the height of the solder balls or bumps 210.

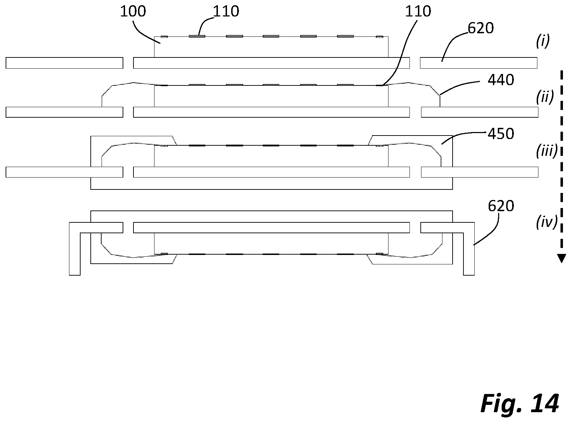

Yet another alternative variant of the process flow is depicted in FIG. 14. In this case there are no solder balls or bumps on the semiconductor die 100 which has exposed thereon the contact pads 110. At (i) is shown the result of the die attach to a lead frame assembly including leads 620 and a die pad or die paddle, similar to that shown in FIG. 12 in FIG. 13; at (ii) is shown the results of wirebonding of bond wires 440 to connect peripheral contact pads 140 to the leads 620; at (iii) is shown the result of partial encapsulation of the die in moulding compound 450; and at (iv) is shown the result of forming the leads 620 into, in this instance, an "L"-shaped profile extending beyond the die and encapsulant.

The skilled person will appreciate that the process stage of forming the leads 420 and 620 shown in FIG. 12, and FIG. 13 and FIG. 14 respectively may include additional process steps such as trimming the leads to an appropriate size and removing supporting busbars.

From reading the present disclosure, other variations and modifications will be apparent to the skilled person. Such variations and modifications may involve equivalent and other features which are already known in the art of semiconductor device packaging and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

It is noted that one or more embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, a single processor or other unit may fulfil the functions of several means recited in the claims [delete if not relevant] and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

## Claims

1. A packaged semiconductor device, comprising:
a semiconductor die, having an array of contact pads, in a central region of a first major surface thereof and for contacting to an array of bumps, pillars or solder balls;
encapsulant, partially encapsulating the semiconductor die and having an aperture in a first major surface thereof exposing the array of contact pads; and
a plurality of leads extending from side faces of the encapsulant and extending beyond the first major surface of the encapsulant.

2. The packaged semiconductor device according to claim 1,
further comprising the respective array of bumps, pillars or solder balls.

3. The packaged semiconductor device according to claim 1 or 2,
Wherein the respective array of bumps, pillars or solder balls, is an array of solder balls.

4. The packaged semiconductor device according to claim 1 or 2,
Wherein the respective array of bumps, pillars or solder balls, is an array of metal-based pillars.

5. The packaged semiconductor device according to any preceding claim,
wherein the solder balls extend further beyond the first surface of the encapsulant than do an end part of the leads, which have an "L" shaped profile.

6. The packaged semiconductor device according to claim 1 or 2,
wherein the leads have a "J" shaped profile, and have an end part which extends beyond, and curves back underneath and towards, the first major surface of the encapsulant.

7. The packaged semiconductor device according to any preceding claim,
further comprising a substrate connected to the semiconductor die by the leads and by the solder balls attaching the contact pads.

8. The packaged semiconductor device according to claim 5 when not dependent on claim 2,
wherein further comprising the array of solder balls.

9. The packaged semiconductor device according to any preceding claim,
wherein the semiconductor die further comprises a further plurality of contact pads around its periphery.

10. The packaged semiconductor device according to any preceding claim,
wherein the further plurality of contact pads are around four sides of the periphery.

11. The packaged semiconductor device according to claim 9 or 10, wherein
the leads are connected to the further plurality of contact pads by wire bonds.

12. The packaged semiconductor device according to any preceding claim, wherein the leads are part of a lead frame assembly which further comprises a die-pad attaching to a second major surface of the semiconductor die.

13. A method of fabricating a packaged semiconductors die, the method comprising:
performing die-attach between a semiconductor die and a lead-frame assembly; wirebonding peripheral contact pads on the semiconductor die to leads of the lead-frame assembly;
encapsulating the semiconductor die in encapsulant, and providing an aperture in a first major surface of the encapsulant exposing a contact pad array on the semiconductor die; and
forming the leads to extend beyond the first major surface of the encapsulant.

14. The method of claim 13, further comprising, before the step of forming the leads, the step of:
providing, on the contact pad array, a one of a group consisting of solder balls, solder bumps, or metal-based pillars.

15. The method of claim 13, further comprising, after the step of encapsulating the semiconductor die in encapsulant, the step of:
providing, on the contact pad array, a one of a group consisting of solder balls, solder bumps, or metal-based pillars.
